(19) Europäisches Patentamt
European Patent Office
Office européen des brevets

(11) **EP 1 508 175 B1**

(12) **EUROPÄISCHE PATENTSCHRIFT**

(45) Veröffentlichungstag und Bekanntmachung des Hinweises auf die Patenterteilung:
**01.07.2009 Patentblatt 2009/27**

(51) Int Cl.:
***H01L 39/24*** *(2006.01)*     ***H01B 12/08*** *(2006.01)*

(21) Anmeldenummer: **03740004.1**

(22) Anmeldetag: **14.05.2003**

(86) Internationale Anmeldenummer:
**PCT/DE2003/001558**

(87) Internationale Veröffentlichungsnummer:
**WO 2003/100875 (04.12.2003 Gazette 2003/49)**

(54) **VERFAHREN ZUR HERSTELLUNG EINES VOLLTRANSPONIERTEN HOCH-Tc-VERBUNDSUPRALEITERS SOWIE NACH DEM VERFAHREN HERGESTELLTER LEITER**

METHOD FOR PRODUCING A FULLY TRANSPOSED HIGH Tc COMPOSITE SUPERCONDUCTOR AND A SUPERCONDUCTOR PRODUCED BY SAID METHOD

PROCEDE POUR REALISER UN SUPRACONDUCTEUR COMPOSITE ENTIEREMENT TRANSPOSE DE Tc ELEVEE ET CONDUCTEUR FABRIQUE SELON CE PROCEDE

(84) Benannte Vertragsstaaten:
**DE FR GB IT**

(30) Priorität: **27.05.2002 DE 10223542**

(43) Veröffentlichungstag der Anmeldung:
**23.02.2005 Patentblatt 2005/08**

(73) Patentinhaber: **SIEMENS AKTIENGESELLSCHAFT**
**80333 München (DE)**

(72) Erfinder: **LEGHISSA, Martino**
**91369 Wiesenthau (DE)**

(56) Entgegenhaltungen:
**WO-A-01/08169**      **WO-A-01/59909**
**DE-A- 2 829 719**

• **FUTAKI N ET AL: "A.C. transport properties of the high-Tc superconducting cable consist of the transposed segment conductor" ADVANCES IN SUPERCONDUCTIVITY XI. PROCEEDINGS OF 11TH INTERNATIONAL SYMPOSIUM ON SUPERCONDUCTIVITY (ISS'98), FUKUOKA, JAPAN, 16. - 19. November 1998, Seiten 971-974, XP008010686 Springer-Verlag, Tokyo, Japan ISBN: 4-431-70256-3**

**Beschreibung**

Die Erfindung bezieht sich auf ein Verfahren zur Herstellung eines volltransponierten Verbundsupraleiters mit mindestens annähernd rechteckigem Querschnitt, der mehrere nach Art eines Röbelstabes zusammengefasste Teilleiter mit Hoch-$T_c$-Supraleitermaterial enthält, welche jeweils einen zumindest annähernd rechteckigen Querschnitt mit einer Breite B aufweisen. Bei dem Verfahren wird den Teilleitern eine Form mit einem in der Ebene der Breite B seitlichen Überstieg in einen Bereich eines benachbarten Teilleiters gegeben und werden die Teilleiter miteinander verseilt. Die Erfindung betrifft ferner einen nach diesem Verfahren hergestellten Leiter. Ein solcher Leiter und ein Verfahren zu seiner Herstellung gehen aus der WO 01/59909 A1 hervor.

Energietechnische Anwendungen von Hoch-$T_c$-Supraleitern (nachfolgend als HTS-Leiter bezeichnet), z.B. zur Realisierung von Transformator-, Maschinen- oder sonstigen Magnetwicklungen erfordern verlustarme Leiter mit Wechselstrom-Nennwerten bis in den Kiloampere-Bereich. Zur Verfügung stehen bisher jedoch nur HTS-Bandleiter geringen Querschnitts und mit Stromtragfähigkeitswerten von bis zu einigen 100 $A_{eff}$ bei 77 K im magnetischen Eigenfeld. Zudem sind diese Bandleiter mechanisch sehr empfindlich, und deren elektrische Eigenschaften hängen stark vom Betrag und der Richtung des lokalen Magnetfeldes ab, in dem sie sich befinden.

Man sieht sich deshalb veranlasst, technisch einsetzbare Hochstrom-Supraleiter aus vielen einzelnen, parallelen Bandleitern in Form von sogenannten Verbundleitern z.B. gemäß der DE 27 36 157 B2 aufzubauen. Für Wechselstromanwendungen im Rahmen von Industriefrequenzen (im Allgemeinen bis 60 Hz) müssen außerdem die nachfolgend als Teilleiter oder Einzelleiter bezeichneten Bandleiter solcher Verbundleiter gegeneinander isoliert und systematisch transponiert bzw. verdrillt werden, um so eine gleichmäßige Stromverteilung im Gesamtquerschnitt und damit geringe Wechselstromverluste zu gewährleisten.

Entsprechende, auch als verseilte Leiter oder Kabelleiter bezeichnete transponierte Verbundleiter mit hoher Wechselstromtragfähigkeit sind prinzipiell bekannt. Sie können folgendermaßen ausgeführt sein:

-   Als sogenannte "Leiterstäbe", z.B. in Form von Röbel-, Schränk- oder Gitter-Stäben, mit Teilleitern aus Kupfer für z.B. große Wechselstrommaschinen,
-   als sogenannte "Drill-Leiter" mit Teilleitern aus Kupfer für Transformatoren oder Drosseln,

oder

-   als sogenannte transponierte "Flach- oder Rundleiter" mit Teilleitern aus metallischen Supraleitern wie z.B. NbTi in Cu (vgl. die genannte DE 27 36 157 B2).

Auch ein Transponieren von HTS-Leitern zur Erhöhung einer Wechselstromtragfähigkeit ist prinzipiell bekannt. Diesbezügliche konkrete Auslegungsbetrachtungen und Konstruktionshinweise beziehen sich

-   auf ein kontinuierliches Transponieren von runden oder praktisch runden HTS-Leitern in Einfach- oder Mehrfach-Seilen (vgl. z.B. sogenanntes "Rutherford Cable" in "IEEE Trans. Appl. Supercond.", Vol. 7, No. 2, Juni 1997, Seiten 958 bis 961),
-   auf ein Erreichen eines kontinuierlichen Transpositionseffektes in Energiekabeln durch Variation der Steigung verseilter, bandförmiger HTS-Teilleiter von Leiterschicht zu Leiterschicht (sogenanntes "Bitch Adjustment"; vgl. WO 96/39705),

und

-   auf ein sogenanntes "In-situ-Transponieren, d.h. das schrittweise Transponieren während der Wicklungsherstellung direkt auf einem Wickelkörper, z.B. einer Transformatorwicklung (vgl. z.B. "IEEE Trans. Appl. Supercond.", Vol. 7, No. 2, Juni 1997, Seiten 298 bis 301).

Eine mögliche Ausführungsform eines volltransponierten HTS-Verbundsupraleiters mit zumindest annähernd rechteckigem Querschnitt, der mehrere nach Art eine Röbelstabes zusammengefasste Teilleiter enthält, sowie eine Vorrichtung zu dessen Herstellung sind der eingangs genannten WO 01/59909 A1 zu entnehmen. Charakteristisch für diesen Verbundleiter ist eine seitliche Biegung seiner bandförmigen Teilleiter mit einem vorbestimmten Biegeradius und einer vorbestimmten Biegezonenlänge. Die Herstellung der entsprechenden "Hochkants-Biegezonen", in denen ein Übertritt in einen Bereich eines benachbarten Teilleiters erfolgt, wird dabei während des Prozesses der Verröbelung vorgenommen. Dieser Prozess erfordert gewisse Mindestgrößen bezüglich der Biegeradien und Biegezonen, nämlich für jeden Teilleiter einen Biegeradius R, der größer als die 100fache Breite B des Teilleiters ist, sowie eine Biege- oder Übertrittszonenlänge H, die größer als das 20fache der Breite B ist. Die Volltranspositionslänge des bekannten HTS-Verbundleiters ist deshalb verhältnismäßig groß. Bevorzugt kommen für ihn bandförmige Teilleiter in Frage, die ein HTS-Material aus dem Stoffsystem BiSrCaCuO enthalten. Entsprechende Teilleiter weisen im Allgemeinen in eine normalleitende Matrix wie vorzugsweise aus Ag oder einer Ag-Legierung eingebettete Kerne aus diesem HTS-Material auf.

Neben solchen Ein- oder Mehrkern-(Teil)Leitern können entsprechende HTS-Leiter in Bandform auch durch ein ein- oder beidseitiges Beschichten eines bandförmigen Trägers mit einem HTS-Material erhalten werden (vgl. z.B. "Physica C", Vol. 185 bis 189, 1991, Seiten 1959 bis 1960; "Appl. Phys. Legt.", Vol. 65, No. 15, 10. Oktober 1994, Seiten 1961 bis 1963; "Appl. Phys. Lett.",

Vol. 71, No. 18, 3. November 1997, Seiten 2695 bis 2697 oder WO 00/46863). Solche Leiter lassen sich jedoch nicht ohne weiteres für einen Aufbau gemäß dem des bekannten HTS-Verbundleiters verwenden, da dort wegen des Schrittes des Hochkantbiegens die Gefahr einer Beschädigung der auf dem Trägerband aufgebrachten HTS-Schicht besteht.

Aufgabe der vorliegenden Erfindung ist es deshalb, das Verfahren mit den eingangs genannten Merkmalen dahingehend auszubilden, dass mit ihm auch volltransponierte HTS-Verbundleiter mit Teilleitern aus beschichteten Trägerbändern herzustellen sind.

Diese Aufgabe wird bezüglich des Herstellungsverfahrens mit den in Anspruch 1 angegebenen Maßnahmen gelöst. Demgemäss ist bei dem Verfahren mit den eingangs genannten Merkmalen eine Trennung des Verfahrensschrittes der Formgebung der Teilleiter von dem Verfahrensschritt des Verseilens vorgesehen, wobei Teilleiter mit Trägerbändern vorgesehen werden, die mit dem supraleitenden Hoch-$T_c$-Material beschichtet sind.

Die mit dieser Ausgestaltung des Verfahrens verbundenen Vorteile sind darin zu sehen, dass der erwähnte Schritt des Hochkantbiegens des fertigen Supraleiters vermieden wird. Damit wird eine Verwendung von mit dem HTS-Material beschichteten Trägerbändern als Teilleiter ermöglicht, die wegen ihres speziellen Schichtaufbaus ein Hochkantbiegen nicht erlauben. Außerdem ist so eine Herstellung verhältnismäßig kurzer Überstiegsbereiche möglich, die folglich auch zu entsprechend kürzeren Volltranspositionslängen führen.

Vorteilhafte Ausgestaltungen des erfindungsgemäßen Verfahrens gehen aus den von Anspruch 1 abhängigen Verfahrensansprüchen hervor.

So kann insbesondere die Formgebung vor dem Schritt der Beschichtung mit dem Supraleitermaterial, beispielsweise durch einen Biegeschritt bezüglich des Trägerbandes, oder durch einen Schneideschritt bezüglich eines Vorkörpers des Trägerbandes, aus dem die gewünschte Form herausgeschnitten wird, vorgesehen werden.

Stattdessen kann die Formgebung auch mittels wenigstens eines Schneideschrittes bezüglich eines mit dem Supraleitermaterial bereits beschichteten Vorkörpers des Trägerbandes vorgenommen werden.

Vorteilhafte Ausgestaltungen eines nach dem erfindungsgemäßen Verfahren hergestellten Verbundsupraleiters gehen aus Anspruch 6 und den von diesem Anspruch abhängigen Sachansprüchen hervor.

So kann vorteilhaft der Verbundsupraleiter durch die Beziehung B < H < 20·B gekennzeichnet sein, wobei H die Ausdehnung des Überstiegsbereichs in Stromführungsrichtung des Verbundsupraleiters ist. Ein solcher Verbundsupraleiter zeichnet sich durch verhältnismäßig kurze Volltranspositionslängen mit kurzen Überstiegsbereichen seiner Teilleiter aus.

Prinzipiell ist es möglich, für den Aufbau des Verbundsupraleiters unterschiedliche Teilleiter, z.B. mit und ohne Supraleitermaterial, und/oder mit verschiedenem Querschnitt zu verwenden. Im Hinblick auf eine gleichmäßige Stromverteilung über den gesamten Verbundleiterquerschnitt ist es jedoch von Vorteil, wenn eine Zusammenfassung von Teilleitern mit gleichem Aufbau vorgesehen wird.

Für den Verbundsupraleiter kommen als Fixierungsmittel insbesondere Verklebungen oder Verlötungen der Teilleiter in Frage. Vorzugsweise wird eine Bandagierung oder Umspinnung vorgesehen, um den Verbundsupraleiter eine hinreichende Flexibilität zu verleihen. Dabei kann im Hinblick auf eine eventuelle spätere Imprägnierung mit einem Kunstharz oder auf einen guten Kühlmittelzutritt die Bandagierung oder Umspinnung insbesondere entsprechend transparent oder saugfähig ausgeführt sein.

Im Hinblick auf eine Verringerung der Wechselstromverluste bei einem Einsatz des Verbundsupraleiters wird dieser vorteilhaft mit Teilleitern aufgebaut, von denen zumindest einige gegeneinander elektrisch isoliert sind.

Vorteilhaft wird für die Teil-leiter des Verbundleiters als supraleitendes Hoch-$T_c$-Material ein Material aus der Familie (RE) $M_2Cu_3O_x$ vorgesehen, wobei die Komponente RE wenigstens ein Seltenes Erdmetall (einschl. Yttrium) und die Komponente M wenigstens ein Erdalkalimetall enthalten. Insbesondere ist das Supraleitermaterial von Typ $YBa_2Cu_3O_x$. Schichten aus entsprechenden HTS-Materialien lassen sich nach bekannten Verfahren mit hoher Stromtragfähigkeit auf bekannten Trägerbändern abscheiden.

Erfindungsgemäße Verbundsupraleiter zeichnen sich deshalb vorteilhaft durch eine hohe Stromtragfähigkeit und eine großtechnische Herstellungsmöglichkeit hinsichtlich großer Leiterlängen aus. Sie sind insbesondere in einer energietechnischen Einrichtung mit Wechselstrombetrieb wie z.B. für Transformatoren, elektrische Maschinen oder Magnete zu verwenden.

Weitere vorteilhafte Ausgestaltungen des Herstellungsverfahren und des nach ihm hergestellten Verbundsupraleiters gehen aus den vorstehend nicht angesprochenen Ansprüchen hervor.

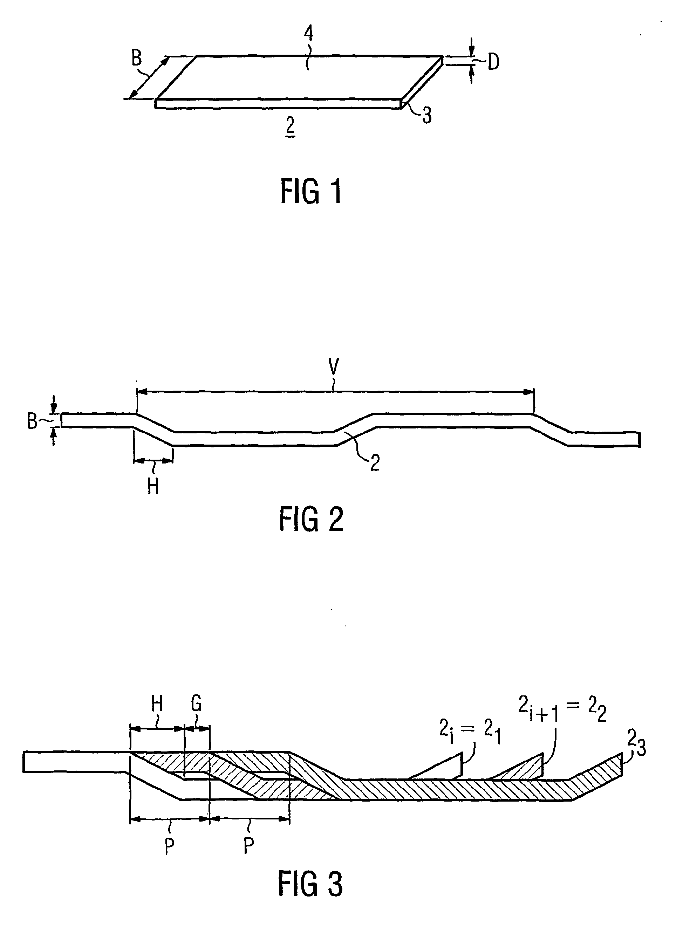

Die Erfindung wird nachfolgend an Hand eines aus der Zeichnung zu entnehmenden bevorzugten Ausführungsbeispieles noch weiter erläutert. Dabei zeigen jeweils schematisch

deren Figur 1     einen für einen Verbundsupraleiter zu verwendenden Teilleiter,

deren Figur 2     die Formgebung eines einzelnen Teilleiters sowie

deren Figur 3     mehrere solcher Teilleiter nach Figur 2, wie sie für einen erfindungsgemäß hergestellten Verbundsupraleiter vorzusehen sind.

In den Figuren sind sich entsprechende Teile mit denselben Bezugszeichen versehen.

Teilleiter, wie sie sich für erfindungsgemäß herzustellende Verbundsupraleiter verwenden lassen, sind allgemein bekannt. Gemäß der Schrägansicht der Figur 1 enthält ein entsprechender Teilleiter 2 ein Trägerband 3, das im Allgemeinen mit wenigstens einer Pufferschicht versehen ist. Auf dieser Pufferschicht ist eine Schicht 4 aus einem HTS-Material abgeschieden. Für diese Schicht kommen neben Materialien aus dem BiSrCa-CuO-Stoffsystem insbesondere Materialien der Familie $(RE)M_2Cu_3O_x$ in Frage. Dabei soll die RE(Rare Earth)-Komponente wenigstens ein Selten-Erd-Element (unser Einschluss von Y) wie z.B. Y enthalten. Bei der M-Komponente handelt es sich um wenigstens ein Erdalkalielement wie z.B. Ba. Hauptvertreter dieses Typs ist $YBa_2Cu_3O_x$ (mit $x = 7-\delta$, das sogenannte YBCO). Selbstverständlich kann mindestens eine der Komponenten dieses Material durch ein anderes aus der jeweiligen Gruppe zumindest teilweise ersetzt sein.

Als Material für das Trägerband 3 kommt beispielsweise Nickel (Ni) oder eine Ni-Legierung in Frage. Die Oberfläche des Trägers kann insbesondere biaxial texturiert sein. Entsprechende bandförmige Substrate sind unter der Bezeichnung "RABITS'" ("Rolling-Assisted-Biaxially-Textured-Substrates") bekannt (vgl. z.B. "Appl. Supercond.", Vol. 4, Nos. 10-11, Seiten 403 bis 427).

Mit mehreren solcher, nach Art eines Röbelstabes zusammengefasster Teilleiter wird ein volltransponierter Verbundsupraleiter mit mindestens annähernd rechteckigem Querschnitt vorgesehen. Sein Aufbau entspricht im Wesentlichen dem des Verbundleiters, der aus der WO 01/59909 A1 zu entnehmen ist. In Anlehnung an die dort verwendete Bezeichnungsweise werden für das Ausführungsbeispiel nach den Figuren 2 und 3 die folgenden Bezeichnungen gewählt:

H = Überstiegsbereiche (bzw. Hochkantbiegezone)
G = Gerade Zone ohne Überstieg
P = H + G = periodischer Überstiegsbereichsabstand
V = Volltranspositionslänge
B = Breite des Teilleiters
D = Dicke des Teilleiters

Vorzugsweise soll für die Länge der Überstiegsbereiche H folgender Zusammenhang gelten:

$$B < H < 20 \cdot B.$$

Für einen Verbundsupraleiter mit einer Teilleiterzahl N soll außerdem folgender Zusammenhang gelten:

$$V = N \cdot P$$

Zur Herstellung eines erfindungsgemäßen Verbundleiters wird der Prozess der Formgebung der Überstiegsbereiche H (z.B. durch Biegen oder Schneiden) sowie des Zusammenfassens (bzw. Verseilens) der Teilleiter $2_i$ (mit i = 1... bis N) getrennt, wobei die nachfolgenden beiden Varianten a) und b) möglich sind:

a) Die Formgebung der Überstiegsbereiche geschieht durch Biegen oder Schneiden des Trägerbandes aus einem größeren Körper wie z.B. Blech vor einem Beschichten mit dem HTS-Material;

b) die Formgebung der Überstiegsbereiche geschieht durch Schneiden eines Bandes bzw. Vorkörpers nach dem Beschichten mit dem HTS-Material. Unter einem Vorkörper sei hierbei ein gegenüber der Breite B breiterer Körper verstanden, aus dem zumindest ein Teilleiter herausschneidbar ist.

Herstellung nach Variante a)

1) Schneiden oder Biegen eines gegebenenfalls vorbehandelten Trägerbandes (z.B. Edelstahlbänder oder walztexturierte Metallbänder wie z.B. RABITS-Bänder aus Nickellegierungen) entsprechend der in Figur 1 gezeigten Ausführungsform mit Überstiegszonen H und geraden Zonen G

2) Aufbringen einer oder mehrerer geeigneter Pufferschichten (z.B. aus YSZ, $CeO_2$, MgO)

3) Aufbringen einer Schicht des HTS-Materials YBCO (oder eines verwandten HTS-Materials der "123"-Materialfamilie $(RE)_1M_2Cu_3O_x$)

4) Gegebenenfalls Aufbringen metallischer Deckschichten oder metallischer Umhüllungen

5) Gegebenenfalls Ummanteln mit einer Isolationsschicht

6) Zusammenfassung von N solcher Teilleiter zu einem volltransponierten Verbundleiter, wobei jeweils benachbarte Teilleiter $2_i$, $2_{i+1}$ um einen periodischen Überstiegsbereichsabstand P gegeneinander versetzt werden

7) Gegebenenfalls Anbringen einer Bandage oder Ummantelung des gesamten Verbundleiters.

Herstellung nach Variante b)

1) Schneiden eines Bandleiters mit einem Supraleitermaterial wie YBCO (oder eines verwandten HTS-Materials der "123"-Materialfamilie) entsprechend der in Figur 1 gezeigten Ausformung mit Überstiegsbereichen H und geraden Zonen G aus einem größeren, beschichteten Körper

2) Gegebenenfalls Ummanteln mit einer Isolationsschicht

3) Zusammenfassung von N solcher Teilleiter zu einem volltransponierten Verbundleiter, wobei jeweils benachbarte Teilleiter um einen periodischen Überstiegsbereichsabstand P gegeneinander versetzt werden

4) Gegebenenfalls Anbringen einer Bandage oder Ummantelung des gesamten Verbundleiters.

Gemäß einem konkreten Ausführungsbeispiel sind als typische geometrische Größen gewählt:

Breite der Teilleiter B = 1 mm ....10 mm
Dicke der Teilleiter D = 0,02 mm ....0,5 mm
Strom pro Teilleiter (bei 77 K, ohne äußeres Magnetfeld) $I_{TL}$ = 10 A...1000 A
Die Anzahl der Teilleiter N richtet sich nach dem gewünschten Gesamtstrom $I_{ges}$ mit N = $I_{Ges}/I_{TL}$.

## Patentansprüche

1. Verfahren zur Herstellung eines volltransponierten Verbundsupraleiters mit rechteckigem Querschnitt, der mehrere nach Art eines Röbelstabes zusammengefasste Teilleiter mit Hoch-$T_c$-Supraleitermaterial enthält, welche jeweils zumindest annähernd rechteckigen Querschnitt mit einer Breite B aufweisen, bei welchem Verfahren den Teilleitern eine Form mit einem in der Ebene der Breite B seitlichen Überstieg in einen Bereich eines benachbarten Teilleiters gegeben wird und die Teilleiter miteinander zu dem volltransponierten Verbundsupraleiter zusammengefasst werden, **gekennzeichnet durch** eine Trennung des Verfahrensschritts der Formgebung der Teilleiter (2; $2_i$) von dem Verfahrensschritt des zusammenfassens der beschichteten Teilleiter derart, dass ein Hochkantbiegen von den beschichteten Teilleitern vermieden wird, wobei Teilleiter (2; $2_i$) mit Trägerbändern (3) vorgesehen werden, die mit dem supraleitenden Hoch-$T_c$-Material beschichtet sind.

2. Verfahren nach Anspruch 1, **dadurch gekennzeichnet, dass** die Formgebung vor dem Schritt der Beschichtung mit dem Supraleitermaterial erfolgt.

3. Verfahren nach Anspruch 2, **dadurch gekennzeichnet, dass** die Formgebung wenigstens einen Biegeschritt bezüglich des Trägerbandes (3) umfasst.

4. Verfahren nach Anspruch 2, **dadurch gekennzeichnet, dass** die Formgebung wenigstens einen Schneideschritt bezüglich eines Vorkörpers des Trägerbandes umfasst.

5. Verfahren nach Anspruch 1, **dadurch gekennzeichnet, dass** die Formgebung mittels wenigstens eines Schneideschrittes bezüglich eines mit dem Supraleitermaterial (4) bereits beschichteten Vorkörpers des Trägerbandes erfolgt.

6. Verbundsupraleiter, hergestellt nach dem Verfahren gemäß einem der vorangehenden Ansprüche, gekennzeichn e t durch die Beziehung B < H < 20.B, wobei H die Ausdehnung des Überstiegs in Stromführungsrichtung des Verbundsupraleiters ist.

7. Verbundsupraleiter nach Anspruch 6, **dadurch gekennzeichnet, dass** für seine Teilleiter (2, $2_i$) jeweils ein Trägerband (3) aus einem Stahl- oder einer Ni-Legierung vorgesehen ist.

8. Verbundsupraleiter nach Anspruch 6 oder 7, **gekennzeichnet durch** Fixierungsmittel in Form von Verklebungen oder Verlötungen der Teilleiter ($2_i$) untereinander oder vorzugsweise **durch** eine Bandagierung oder Umspinnung.

9. Verbundsupraleiter nach Anspruch 8, **gekennzeichnet durch** eine für ein Imprägniermittel oder ein Kühlmittel durchlässige oder saugfähige Bandagierung oder Umspinnung.

10. Verbundsupraleiter nach einem der Ansprüche 6 bis 9, **dadurch gekennzeichnet, dass** zumindest einige seiner Teilleiter ($2_i$) gegenseitig elektrisch isoliert sind.

11. Verbundsupraleiter nach einem der Ansprüche 6 bis 10, **dadurch gekennzeichnet, dass** als supraleitendes Hoch-$T_c$-Material ein Material aus der Familie $(RE)M_2Cu_3O_x$ vorgesehen ist, wobei die Komponente RE wenigstens ein Seltenes Erdmetall (einschl. Yttrium) und die Komponente M wenigstens ein Erdalkalimetall enthalten.

12. Verbundsupraleiter nach Anspruch 11, **dadurch gekennzeichnet, dass** das Supraleitermaterial vom Typ $YBa_2Cu_3O_x$ ist.

## Claims

1. Method for producing a fully transposed composition superconductor with an at least approximately rectangular cross section, which contains two or more conductor elements that are combined in the form of a transposed conductor bar, are composed of high-$T_c$ superconductor material and each have an at least approximately rectangular cross section with a width B, in which method the conductor elements are produced in a shape with a lateral projection, on the plane of the width B, into an area of an adjacent conductor element, and the conductor elements are combined with one another to form the fully transposed composition superconductor, **characterized by** separation of the method step of shaping of the conductor elements $(2; 2_i)$ from the method step of combining the coated conductor elements in such a way that upright bending of the coated conductor elements is avoided, with conductor elements $(2; 2_i)$ being provided with supporting ribbons (3) which are coated with the superconductive high-$T_c$ material.

2. Method according to Claim 1, **characterized in that** the shaping is carried out before the step of coating with the superconductor material.

3. Method according to Claim 2, **characterized in that** the shaping comprises at least one bending step for the supporting ribbon (3).

4. Method according to Claim 2, **characterized in that** the shaping comprises at least one cutting step relating to an initial body of the supporting ribbon.

5. Method according to Claim 1, **characterized in that** the shaping is carried out by means of at least one cutting step relating to an initial body of the supporting ribbon which is already coated with the superconductor material (4).

6. Composite superconductor, produced using the method according to one of the preceding claims, **characterized by** the relationship B < H < 20.B, where H is the extent of the projection in the current-carrying direction of the composite superconductor.

7. Composite superconductor according to Claim 6, **characterized in that** a supporting ribbon (3) composed of a steel alloy or of a nickel alloy is provided for each of its conductor elements $(2, 2_i)$ .

8. Composite superconductor according to Claim 6 or 7, **characterized by** fixing means in the form of adhesively bonded joints or soldered joints between the conductor elements $(2_i)$ or, preferably, by bandaging or braiding.

9. Composite superconductor according to Claim 8, **characterized by** bandaging or braiding that is transparent or capable of suction for an impregnation medium or a coolant.

10. Composite superconductor according to one of Claims 6 to 9, **characterized in that** at least some of its conductor elements $(2_i)$ are electrically isolated from one another.

11. Composite superconductor according to one of Claims 6 to 10, **characterized in that** a material from the family $(RE)M_2Cu_3O_x$ is provided as the superconductive high-$T_c$ material, with the component RE containing at least one rare earth metal (including yttrium), and the component M containing at least one alkaline earth metal.

12. Composite superconductor according to Claim 11, **characterized in that** the superconductor material is of the $YBa_2Cu_3O_x$ type.

**Revendications**

1. Procédé de fabrication d'un supraconducteur composite entièrement transposé, de section transversale au moins à peu près rectangulaire, qui comporte plusieurs sous-conducteurs en matériau supraconducteur à $T_c$ haute rassemblés à la façon d'un barre Robel et ayant respectivement une section transversale au moins à peu près rectangulaire d'une largeur B, procédé dans lequel il est donné, dans une partie d'un sous-conducteur voisin, aux sous-conducteurs une forme ayant un dépassement latéral dans le plan de la largeur B et les sous-conducteurs sont rassemblés entre eux en le supraconducteur composite entièrement transposé, **caractérisé par** une séparation du stade de procédé du façonnage des sous-conducteurs ( 2 ; $2_i$ ) du stade de procédé du rassemblement des sous-conducteurs revêtus, de façon à éviter une flexion de chant des sous-conducteurs revêtus, dans lequel des sous-conducteurs ( 2 ; $2_i$ ) sont munis de rubans ( 3 ) de support, qui sont revêtus du matériau supraconducteur à $T_c$ haute.

2. Procédé suivant la revendication 1, **caractérisé en ce que** l'on effectue le façonnage avant le stade du revêtement par le matériau supraconducteur.

3. Procédé suivant la revendication 2, **caractérisé en ce que** le façonnage comprend au moins un stade de flexion en ce qui concerne le ruban ( 3 ) de support.

4. Procédé suivant la revendication 2, **caractérisé en ce que** le façonnage comprend au moins un stade de coupe en ce qui concerne une ébauche du ruban de support.

5. Procédé suivant la revendication 1, **caractérisé en ce que** l'on effectue le façonnage à l'aide d'au moins un stade de coupe en ce qui concerne une ébauche du ruban de support déjà revêtue du matériau ( 4 ) supraconducteur.

6. Supraconducteur composite fabriqué par le procédé suivant l'une des revendications précédentes, **caractérisé par** la relation
B < H < 20-B, H étant l'étendue du dépassement dans la direction de passage du courant du supraconducteur composite.

7. Supraconducteur composite suivant la revendication 6, **caractérisé en ce que**, pour ses sous-conducteurs ( 2, $2_i$ ), est prévu respectivement un ruban ( 3 ) de support en un alliage d'acier ou en un alliage de Ni.

8. Supraconducteur composite suivant la revendication 6 ou 7, **caractérisé par** des moyens d'immobilisation sous la forme de collures ou de brasures des sous-conducteurs ( $2_i$ ) entre eux ou, de préférence, par un rubanage ou un guipage.

9. Supraconducteur composite suivant la revendication 8, **caractérisé par** un rubanage ou un guipage perméable ou susceptible d'aspirer un agent d'imprégnation ou un agent de refroidissement.

10. Supraconducteur composite suivant l'une des revendications 6 à 9, **caractérisé en ce qu'**au moins certains de ces sous-conducteurs ( $2_i$ ) sont isolés électriquement mutuellement.

11. Supraconducteur composite suivant l'une des revendications 6 à 10, **caractérisé en ce qu'**il est prévu, comme matériau supraconducteur à $T_c$ haute, un matériau de la famille ( RE ) $M_2Cu_3O_x$, le constituant RE contenant au moins un métal de terre rare ( y compris l'yttrium ) et le constituant M au moins un métal alcalino-terreux.

12. Supraconducteur composite suivant la revendication 11, **caractérisé en ce que** le matériau supraconducteur est du type $YBa_2Cu_3O_x$.

B

4

D

2

3

**FIG 1**

V

B

H

2

**FIG 2**

H   G

$2_i = 2_1$

$2_{i+1} = 2_2$

$2_3$

P   P

**FIG 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0159909 A1
- DE 2736157 B2
- WO 9639705 A
- WO 0046863 A

**In der Beschreibung aufgeführte Nicht-Patentliteratur**

- Rutherford Cable. *IEEE Trans. Appl. Supercond.,* Juni 1997, vol. 7 (2), 958-961
- *IEEE Trans. Appl. Supercond.,* Juni 1997, vol. 7 (2), 298-301
- *Physica C,* 1991, vol. 185-189, 1959-1960
- *Appl. Phys. Legt.,* 10. Oktober 1994, vol. 65 (15), 1961-1963
- *Appl. Phys. Lett.,* 03. November 1997, vol. 71 (18), 2695-2697
- *Appl. Supercond.,* vol. 4 (10-11), 403-427